# EUROPEAN PATENT APPLICATION

(11) **EP 1 855 329 A1**
(43) Date of publication of application: **14.11.2007**
(21) Application number: 06714556.5
(22) Date of filing: 24.02.2006
(51) Int. Cl.: H01L 41/083, C04B 35/49, H01L 41/187, H01L 41/22, H01L 41/24, H02N 2/00

(54) **MULTILAYER PIEZOELECTRIC ELEMENT**

(30) Priority: 01.03.2005 JP 2005056223
(71) Applicant: Ibiden Co., Ltd., Oogaki City 503-8604 (JP); Dai Nippon Toryo Co., Ltd., Osaka-City, Osaka 554-0012 (JP)
(72) Inventor: ITO, Atsushi, ta, Ibigawa-cho, Ibi-gun, Gifu, 5010695 (JP); MATSUNO, Yoshiya, ta, Ibigawa-cho, Ibi-gun, Gifu, 5010695 (JP); IDO, Takahiko, ta, Ibigawa-cho, Ibi-gun, Gifu, 5010695 (JP); SHIKANO, Haruhide, ta, Ibigawa-cho, Ibi-gun, Gifu, 5010695 (JP); FUKUYASU, Shigeo, -chome, Konohana-ku, Osaka-shi, Osaka, 5 (JP); MATSUYAMA, Takuo, -chome, Konohana-ku, Osaka-shi, Osaka, 5 (JP)
(74) Representative: HOFFMANN EITLE
(86) International application number: PCT/JP2006/303417
(87) International publication number: WO 2006/093043

(57) **Abstract**

A multilayer piezoelectric element 20 includes a plurality of piezoelectric layers 11 and a plurality of inner electrode layers 12 alternately stacked, a first outer electrode 18 that electrically couples together every other inner electrode layers 12 in the lamination direction, and a second outer electrode 19 that electrically couples together the remaining inner electrode layers 12. The piezoelectric layers 11 are obtained by molding and firing a mixture containing a Pb component, a Zr component, a Ti component, a Sr component, a Nb component, and a Zn component. When the piezoelectric layers 11 are each represented by general formula Pb(ZrₐTi₁₋ₐ)O₃ + bSrO + cNbO_{2.5} + dZnO, the relative amounts of the individual components, for example, satisfy the relationships **a** = 0.51, **b** = 2.0 × 10⁻², **c** = 1.50 × 10⁻², **d** = 0.5×10⁻², and **c**/**d** = 3.0.

## Description

### Technical Field

The present invention relates to multilayer piezoelectric element.

### Background Art

In piezoelectric materials, the application of a stress causes electric polarization, and the application of an electric field causes a strain. The occurrence of electric polarization due to the stress and the occurrence of strain due to the electric field are physical phenomena based on the same principle. Such phenomena are referred to as a piezoelectric effect. Furthermore, multilayer piezoelectric elements use such a piezoelectric effect of piezoelectric materials, and crystal oscillators, electrometers, sensors, motors, automotive parts, and various other products have been put into practical use.
For example, as disclosed in Patent Documents 1 and 2, a multilayer piezoelectric element is known in which a plurality of piezoelectric layers and a plurality of inner electrode layers are alternately stacked, every other inner electrode layers are electrically coupled to form a first outer electrode, the remaining inner electrodes are electrically coupled to form a second outer electrode, and a voltage is applied between the two outer electrodes.

A typical piezoelectric material is lead zirconate titanate (PZT) having a perovskite crystal structure, and there have been many reports of various improvements using PZT as a base. For example, Patent Document 3 discloses 0.98Pb(Zr_{0.52}Ti_{0.48})O₃-0.02Sr(K_{0.25}Nb_{0.75})O₃ as a piezoelectric material. It is also described that this piezoelectric material has a Curie temperature Tc of 347.3°C and a piezoelectric constant d₃₃ of 440 pm/V measured by a resonator measurement method. The Curie temperature Tc is a ferroelectric transition temperature to a paraelectric phase, and spontaneous polarization disappears at a temperature higher than the Cuie temperature Tc. Therefore, in view of the maintenance of the piezoelectric effect at a high temperature, the Curie temperature Tc is preferably as high as possible. From this viewpoint, the piezoelectric material disclosed in Patent Document 3 has excellent high temperature resistance because the Curie temperature Tc is 300°C or more. The piezoelectric constant d₃₃ is an index indicating an amount of displacement when an electric field (V/m) is applied to a piezoelectric material. When a piezoelectric material is used for an actuator, the piezoelectric constant d₃₃ is preferably as high as possible. From this viewpoint, the piezoelectric material disclosed in Patent Document 3 is desirable because the piezoelectric constant d₃₃ is as relatively high as 440 pm/V. The piezoelectric constant d₃₃ is generally measured by a resonator measurement method. In a two-digit number attached after d, the left number denotes the electric field direction, the right number denotes the displacement direction, and the number "3" denotes the polarization direction.
Patent Document 1: Japanese Patent Laid-Open Publication Hei4-76969
Patent Document 2: Japanese Patent Laid-Open Publication Hei4-57375
Patent Document 3: Published Japanese translation of a PCT application No. 2001-515835

### Disclosure of Invention

In the process of searching for materials that have characteristics superior to those of the piezoelectric material according to Patent Document 1, the present inventors have found that there are cases where the piezoelectric constant d₃₃ obtained by the resonator measurement method does not agree with the piezoelectric constant d₃₃ obtained on the basis of a displacement occurring when an electric field is actually applied to a piezoelectric material (hereinafter referred to as the "piezoelectric constant d₃₃ by actual displacement"), and even if the piezoelectric constant d₃₃ obtained by the resonator measurement is the same for piezoelectric materials, different piezoelectric constants d₃₃ by actual displacement are obtained. It has also been found that in known piezoelectric materials, there is a tendency in which as the Curie temperature Tc is increased, the piezoelectric constant d₃₃ is decreased, while as the piezoelectric constant d₃₃ is increased, the Curie temperature Tc is decreased. Because of the findings described above, it has been expected that there would be considerable difficulties in creating a piezoelectric material that has excellent high temperature resistance and that produces a large displacement when an electric field is applied, compared with the known piezoelectric materials. Furthermore, in a multilayer piezoelectric element, in addition to the requirement that each piezoelectric layer exhibits the piezoelectric effect properly when the multilayer piezoelectric element is continuously operated, it is also required that the multilayer piezoelectric element as a whole exhibits the piezoelectric effect properly. Consequently, it is not only required that both the piezoelectric constant d₃₃ and the Curie temperature Tc are high, but also that these physical properties do not change greatly after a load test, such as a heat-cycle test, is performed.

The present invention has been achieved in order to overcome such difficult problems. It is an object of the invention to provide a multilayer piezoelectric element that has excellent high temperature resistance and produces a large actual displacement when a voltage is applied.

In order to solve the above-mentioned problem, the inventors intensively researched piezoelectric materials including lead zirconate titanate as a base. As a result, the inventors found a piezoelectric material having excellent high temperature resistance and a large actual displacement when an electric field is applied, resulting in the completion of the present invention.

A multilayer piezoelectric element according to the present invention includes a plurality of piezoelectric layers and a plurality of inner electrode layers alternately stacked;
a first outer electrode that electrically couples together every other inner electrode layers in the lamination direction; and
a second outer electrode that electrically couples together the remaining inner electrode layers,
wherein the piezoelectric layers are obtained by molding and firing a mixture containing a Pb component, a Zr component, a Ti component, a Sr component, a Nb component, and a Zn component; and
when the piezoelectric layers are each represented by general formula Pb(ZrₐTi_{1 a})0₃ + bSrO + cNbO_{2.5} 5 + dZnO, the relative amounts of the individual components satisfy the relationships: $0.51 \leq a \leq 0.54 ,$ $1.1 \times {10}^{- 2} \leq b \leq 6.0 \times {10}^{- 2} ,$ $0.9 \times {10}^{- 2} \leq c \leq 4.25 \times {10}^{- 2} ,$ $0.1 \times {10}^{- 2} \leq d \leq 1.25 \times {10}^{- 2} ,$ and $2.9 \leq c / d \leq 15.0.$

The multilayer piezoelectric element of the present invention has not only excellent high temperature resistance but also a large actual displacement when an electric field is applied, and thus can stably exhibit the piezoelectric effect at a high temperature over a long time. Although the reason why the multilayer piezoelectric element of the present invention has the excellent functional properties is not known, the inventors suppose the following reason: As in the multilayer piezoelectric element of the present invention, when piezoelectric layers satisfying the above general formula (satisfying the numeral ranges of a to d) is used, a crystal structure is easily made asymmetric because of the strong crystal anisotropy at room temperature, and thus the material is little affected by thermal oscillation even at a high temperature and is little put into a nonpolar state. Therefore, it is thought that the material has excellent high temperature resistance. It is also thought that a crystal axis of a polycrystal is rotated by applying a voltage to produce strain, and an actual displacement is increased due to the large strain.

### Brief Description of the Drawings

Figs. 1(a) to 1(c) are each a perspective view of a multilayer piezoelectric element during a process of fabrication, Fig. 1(a) being a perspective view of a stacking step, Fig. 1(b) being a perspective view of an insulating portion forming step, Fig. 1(c) being a perspective view of an outer electrode forming step.
Fig. 2 is a schematic diagram illustrating outer electrodes which have been subjected to outer-shape processing.
Fig. 3 is a circuit diagram when a voltage is applied to a multilayer piezoelectric element.
Fig. 4 is a circuit diagram when a voltage is applied to a multilayer piezoelectric element.

### Best Mode for Carrying Out the Invention

In the multilayer piezoelectric element of the present invention, when the value a is less than 0.51 or greater than 0.54, the actual displacement tends to be low with respect to the applied voltage. Therefore, the value of a is preferably, 0.51 s a s 0.54. More preferably, 0.53 ≤ a ≤ 0.54 from the standpoint that it is possible to suppress a decrease in the piezoelectric constant d₃₃ by actual displacement even if the composition fluctuates locally.

When the value **b** is less than 1.1 × 10⁻², the actual displacement tends to be low with respect to the applied voltage. If the value **b** is greater than 6.0 × 10⁻², the Curie temperature Tc tends to be low. Therefore, the value of **b** is preferably, 1.1 × 10⁻² ≤ **b** ≤ 6.0 × 10⁻².

When the value c is less than 0.9 × 10⁻² or greater than 4.25 × 10⁻², the actual displacement tends to be low with respect to the applied voltage. Therefore, the value of c is preferably, 0.9 × 10⁻² ≤ **c** ≤ 4.25 × 10⁻².

When the value **d** is less than 0.1 × 10⁻², the actual displacement tends to be low with respect to the applied voltage. If the value **d** is greater than 1.25 × 10⁻², the Curie temperature Tc tends to be low. Therefore, the value of **d** is preferably 0.1 × 10⁻²≤ d ≤ 1.25 × 10⁻².

Furthermore even if the value **c** satisfies the relationship 0.9 × 10 ² ≤ **c** ≤ 4.25 × 10 ² and the value d satisfies 0.1 × 10 ² ≤ **d** ≤ 1.25 × 10⁻², when the ratio **c**/**d** is less than 2.9 or greater than 15.0, the actual displacement tends to be low with respect to the applied voltage. Therefore, the value of **c**/**d** is preferably, 2.9 ≤ **c**/**d** ≤ 15.0.

In the multilayer piezoelectric element of the present invention, when the piezoelectric layers are composed of a piezoelectric material that satisfies the general formula described above (wherein values a to d satisfy the relationships described above), preferably, the average displacement per piezoelectric layer is 0.18 µm or more (more preferably 0.20 µm or more) when displacement is measured by an electric micrometer while applying a DC electric field from 0 to 200 V at room temperature, and the Curie temperature Tc of the piezoelectric layers is 300°C or higher (in particular, 325°C or higher, more preferably 340°C or higher). In such a case, the actual displacement is high with respect to the applied voltage, and if the multilayer piezoelectric element is used under a temperature condition lower than the Curie temperature Tc, spontaneous polarization does not disappear. Consequently, the piezoelectric effect can be obtained for a long period of time under high temperatures.

In the multilayer piezoelectric element of the present invention, the piezoelectric layers are not necessarily composed of a piezoelectric material that satisfies the general formula described above (wherein values **a** to **d** satisfy the relationships described above). Alternatively, the piezoelectric layers may contain lead zirconate titanate, as a base, and a Zn component, the Curie temperature Tc of the piezoelectric layers is 300°C or higher, and the average displacement per piezoelectric layer is 0.18 µm or more (preferably 0.20 µm or more) when displacement is measured by an electric micrometer while applying a DC electric field, between a first outer electrode and a second outer electrode, from 0 to 200 V at room temperature. In such a case, the actual displacement is high with respect to the applied voltage, and when the multilayer piezoelectric element is used under a temperature condition lower than the Curie temperature Tc, spontaneous polarization does not disappear. Consequently, the piezoelectric effect can be obtained for a long period of time under high temperatures. In the multilayer piezoelectric element, preferably, the piezoelectric layers contain a Pb component, a Zr component, a Ti component, a Sr component, a Nb component, and a Zn component.

The multilayer piezoelectric element of the present invention can be applied to various piezoelectric devices. Applicable examples of piezoelectric devices include a piezoelectric actuator, a piezoelectric buzzer, an ultrasonic cleaner, an ultrasonic motor, and an ink jet head. Since the multilayer piezoelectric element of the present invention stably exhibits the piezoelectric effect over a long time at a high temperature, the multilayer piezoelectric element is preferably used as an automobile injector, and particularly as an injector of a diesel engine common-rail system. For example, the multilayer piezoelectric element is built in near a needle in an injector so that the multilayer piezoelectric element is displaced by controlling the voltage applied between the first outer electrode and the second outer electrode in order to control opening and closing of a needle valve of the injector. In addition, an injector of a common rail system is required to have high responsiveness, and a type using a multilayer piezoelectric element is useful because it responds at a higher speed than the injection interval of a conventional solenoid type.

The piezoelectric element of the present invention is manufactured through, for example, (1) a raw material mixing step, (2) a mixture grinding step, (3) a calcining and grinding step, (4) a binder mixing step, (5) a granulating step, (6) a molding step, (7) a firing step, (8) a processing step, (9) a stacking step, (10) an insulating portion forming step, (11) an outer electrode forming step, and (12) polarization step. Each of the steps will be described below.

### (1) Raw material mixing step

First, necessary amounts of powders of a Pb component, a Zr component, a Ti component, a Sr component, a Nb component, and Zn component are weighed as starting materials and mixed. At this time, the types of impurities contained in the raw materials used and the particle size distributions thereof are previously determined.

The Pb component used is not particularly limited as long as the Pb component can form a lead oxide by firing, and any one of various Pb components may be used. Examples of such a Pb component include oxides such as Pb₃O₄ (red lead) and PbO.

The Zr component used is not particularly limited as long as the Zr component can form a zirconium oxide by firing, and any one of various Zr components may be used. Examples of such a Zr component include zirconium oxides such as zirconium dioxide, and zirconium hydroxide.

The Ti component used is not particularly limited as long as the Ti component can form a titanium oxide by firing, and any one of various Ti components may be used. Examples of such a Ti component include titanium oxides such as titanium dioxide, and titanium hydroxide.

The Sr component used is not particularly limited as long as the Sr component can form a strontium oxide by firing, and any one of various Sr components may be used. Examples of such a Sr component include strontium oxides and strontium carbonate.

The Nb component used is not particularly limited as long as the Nb component can form a niobium oxide by firing, and any one of various Nb components may be used. Examples of such a Nb component include niobium oxides such as niobium pentoxide.

The Zn component used is not particularly limited as long as the Zn component can form a zinc oxide by firing, and any one of various Zn components may be used. Examples of such a Zn component include zinc oxides, zinc nitrate, and zinc carbonate. Among these compounds, zinc oxide is preferably used in view of stabilization of the piezoelectric constant.

### (2) Mixture grinding step

The raw material mixture prepared in the step (1) and pure water are added to a ball mill, and the resultant mixture is mixed and then dried. The mixing is preferably performed at a rotational speed of at least 200 rpm for a mixing time of 5 to 30 hours, and the amount of the pure water mixed is preferably 50 to 75% of the total weight. The mixture is preferably ground to become uniform over the whole. This is because when the mixture is nonuniform, reactivity in calcining and the piezoelectric characteristics of a final product are greatly affected.

### (3) Calcining and grinding step

The ground mixture of the raw materials is calcined in a powder state. Before the calcining, the mixture is previously dried at, for example, 80°C to 150°C for about 1 hour in order to remove excess moisture. Then, the mixture is calcined in an oxidizing atmosphere such as air of 700°C to 1000°C (preferably 800°C to 900°C) for 1 to 7 hours. After the calcining, the powder is ground to an average particle size of 0.1 to 2.0 µm, preferably 0.1 to 1.0 µm, using a grinding apparatus such as a ball mill. In order to uniformly grind, grinding is preferably performed by a wet system using water. The grinding time is not particularly limited but is, for example, 5 to 30 hours and preferably 10 to 20 hours. After the grinding, the powder is dried to obtain a raw material powder.

### (4) Binder mixing step

In order to facilitate molding, a binder may be uniformly added to the powder. As the binder used for molding, a resin, e.g., polyvinyl alcohol, can be used. The ratio by weight of the binder is preferably 0.5% or less. When the ratio by weight exceeds 0.5%, the electric properties and piezoelectricity may be degraded, and reduction of an oxide easily takes place.

### (5) Granulating step

The raw material powder containing the binder is granulated. The resulting granules preferably have a grain size of 1 to 20 µm and a shape such as a circular shape, an elliptical shape, a polygonal shape, or a square shape.

### (6) Molding step

The granules are molded into a desired shape. The molding may be performed by either dry molding or wet molding. Dry molding methods include a powder compression method in which granules are charged in a mold and then molded under pressure, and a hydrostatic pressing method. Wet molding methods include a doctor blade method in which a slurry or paste of raw material powder is molded into a thin plate, an extrusion molding method, and a roll molding method. Other known molding methods may be used.

### (7) Firing step

The molded product is fired to form a sintered body. The firing temperature is preferably 1050°C to 1250°C, and the retention time is preferably 1 to 8 hours. In firing, the molded product may be sealed in a vessel and fired in a PbO atmosphere. Therefore, evaporation of PbO can be prevented. The temperature may be increased or decreased stepwisely until or after the firing retention time has passed. When the molded product after the molding step contains the binder, the molded product is preferably degreased and decarbonized at a temperature of 200°C to 500°C.

### (8) Processing step

Polishing, cutting, surface finishing, or the like is performed so that sintered bodies have a predetermined size. Thereby, sheet-like sintered bodies are obtained.

### (9) Stacking step

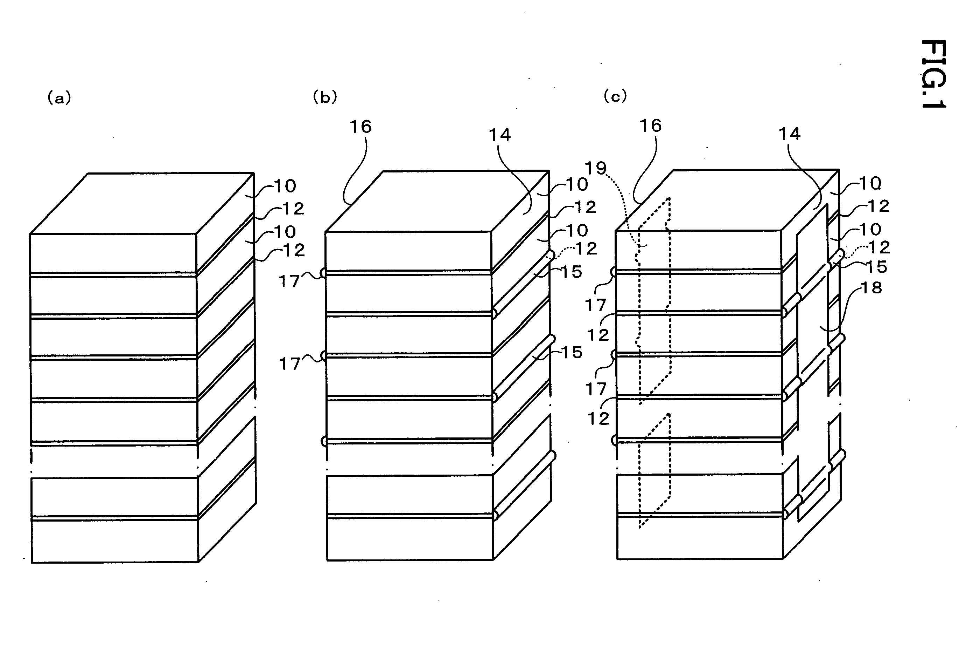

As shown in Fig. 1(a), a plurality of sheet-like sintered bodies 10 (for example, 200 sintered bodies) are prepared. The sintered bodies are stacked in sequence with a metal paste for forming an inner electrode 12 being applied onto each sintered body. After the stacking is complete, hot press bonding is performed under a pressure of 1 to 2 MPa at 700°C to 800°C for 2 hours. Thereby, a laminate is obtained in which layers of the sintered bodies 10 and layers of the inner electrodes 12 are alternately stacked. As the metal paste, for example, a silver paste is used. The thickness of each inner electrode 12 is preferably 2 to 20 µm. When the thickness is less than 2 µm, in some cases, the sintered bodies may not be covered fully, resulting in a decrease in the piezoelectric effect. When the thickness exceeds 20 µm, the inner electrodes may inhibit strain, resulting in a decrease in the piezoelectric effect.

### (10) Insulating portion forming step

As shown in Fig. 1(b), in a side face 14 of the laminate, every other layers of portions the inner electrodes 12 exposed to outside in the lamination direction are covered with an electrical insulator to form insulating portions 15. In a side face 16 opposing the side face 14, every other layers of portions the inner electrodes 12 exposed to outside in the lamination direction are covered with the electrical insulator to form insulating portions 17. Note that the inner electrodes 12 provided with the insulating portions 15 are not provided with the insulating portions 17, and the inner electrodes 12 provided with the insulating portions 17 are not provided with the insulating portions 15. As the electrical insulator, insulating glass, resin, or the like is used. Examples of the glass include those containing SiO₂, CaO, or the like. Examples of the insulating resin include epoxy resins, melamine resins, and polyimide resins. The electrical insulator may be composed of a thermosetting resin, a thermoplastic resin, or a photocurable resin. The electrical insulator may be composed of one or two or more selected from these materials.

### (11) outer electrode forming step

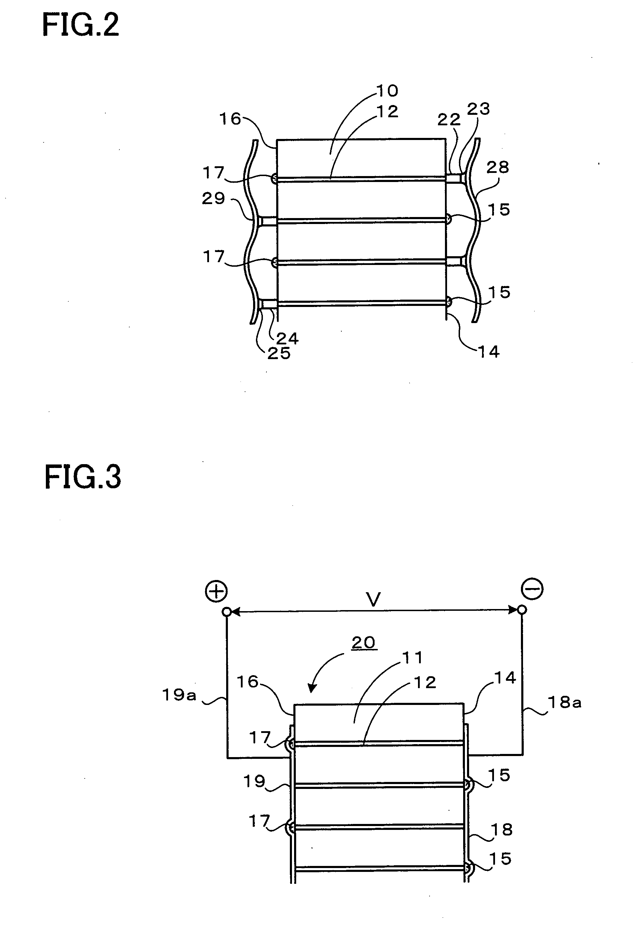

As shown in Fig. 1(c), a first outer electrode 18 is formed so as to extend from the upper portion to the lower portion of the side face 14, and a second outer electrode 19 is formed so as to extend from the upper portion to the lower portion of the side face 16. The first outer electrode 18 electrically couples together the inner electrodes 12 which are exposed to outside on the side face 14 (i.e., which are not provided with the insulating portions 15) out of all the inner electrodes 12. The second outer electrode 19 electrically couples together the inner electrodes 12 which are exposed to outside on the side face 16 (i.e., which are not provided with the insulating portions 17) out of all the inner electrodes 12. Thereby, the first outer electrode 18 which electrically couples together every other inner electrodes 12 in the lamination direction, and the second outer electrode 19 which electrically couples together the remaining inner electrodes 12 in the lamination direction are obtained. The outer electrodes 18 and 19 are formed by one of two methods, i.e., a method in which a metal paste is used and a method in which electrodes which have been previously subjected to outer-shape processing are bonded to the laminate. The two methods will be described below.
(i) Metal paste method
   As shown in Fig. 1(c), a metal paste, such as Ag, Cu, or Pt paste, is directly applied to each of the side faces 14 and 16 of the laminate, followed by drying and hardening, to form a first outer electrode 18 and a second outer electrode 19. In such a case, each of the outer electrodes 18 and 19 may be formed using one type of metal paste, or each of the outer electrodes 18 and 19 may be formed using a mixture of two or more types of metal paste. Furthermore, each of the outer electrodes 18 and 19 may be formed using a metal multilayer including two or more layers.
(ii) Outer-shape processing method
   As shown in Fig. 2, conductive sheets composed of Cu or the like are subjected to outer-shape processing to form a desired size and a shape that allows expansion and contraction in the lamination direction. Thereby, outer electrodes 28 and 29 are obtained. The resulting outer electrodes 28 and 29 are bonded to the side faces 14 and 16 of the laminate, respectively. In the example shown in Fig. 2, the shape that allows expansion and contraction in the lamination direction is a corrugated shape like a sine curve. Alternatively, portions facing the insulating portions 15 and 17 are hollowed out in an arch-like shape. The outer electrodes 28 and 29 which have been subjected to outer-shape processing are respectively bonded to copper posts 22 and 24, which are connected to inner electrodes 12, with solder 23 and 25 therebetween. When displacement occurs in the multilayer piezoelectric element under an applied voltage, the outer electrodes 28 and 29 expand and contract following the displacement, and thus the displacement is not inhibited.

### (12) Polarization step

The layers of the sintered bodies 10 thus obtained are isotropic and do not exhibit piezoelectricity. Consequently, polarization treatment is performed in which a DC electric field that is larger than the intrinsic coercive electric field is applied to align the direction of spontaneous polarization. The polarization treatment is performed, for example, by immersing the workpiece in an insulating oil at about 100°C for several tens of minutes. As a result, as shown in Fig. 3, the sintered bodies 10 become piezoelectric bodies 11. Thereby, a multilayer piezoelectric element 20 is obtained. By fixing leads 18a and 19a to the first and second outer electrodes 18 and 19, respectively, a voltage V can be applied between the electrodes 18 and 19.

The multilayer piezoelectric element can be fabricated by the method described above. The multilayer piezoelectric element may be fabricated by a method other than that described above. For example, in another method which may be employed, the same steps as those described above are carried out up to the molding step, a metal paste for forming inner electrodes is applied, by a known method such as printing, to green piezoelectric material sheets which have been subjected to the molding step, the sheets are then stacked and integrated by heating and press bonding, followed by firing at 1,100°C to 1,200°C, and then the insulating portion forming step and subsequent steps described above are carried out. This method is referred to as a "lamination co-firing method". Additionally, the polarization treatment may be performed to each piezoelectric body after it has been subjected to the firing step.

### EXAMPLES

### [Examples 1-1 to 1-4 and Comparative Examples 1-1 and 1-2]

First, PbO as a Pb component, ZrO₂ as a Zr component, TiO₂ as a Ti component, SrO as a Sr component, Nb₂O₅ as a Nb component, and ZnO as Zn component were weighed so as to satisfy each of the compositions a to d after firing in Examples 1-1 to 1-4 and Comparative Examples 1-1 and 1-2 shown in Table 1. The mixture of the components and pure water were added to a ball mill, and the resultant mixture was mixed and ground for 20 hours and then dried. The amount of the pure water added was 65% of the total weight. The rotational speed of the ball mill was 500 rpm. Then, the mixture ground with the ball mill was dehydrated by drying at 100°C for 24 hours, and then calcined in air at 850°C for 2 hours. After calcining, the powder was ground by a ball mill for 20 hours. The average particle size after grinding was 0.8 µm. Then, 0.5% by weight of polyvinyl alcohol was added as a binder to the resulting powder, and the resulting mixture was granulated to a grain size of about 1.4 µm. The granules were charged in a square mold and then molded under a pressure of 130 MPa. The molded product was fired in a Pb atmosphere to form a sintered body. In firing, the heating rate was 100 °C/hour, and the molded product was maintained for 2 hours at a temperature of 1100°C to 1200°C after the temperature was attained. The sintered body was cut into a predetermined size using a machining center and then polished for planarizing the cut sides to obtain a sintered body of 7 mm in length, 7 mm in width, and 0.5 mm in thickness.

Subsequently, the surface of each sintered body was subjected to surface polishing parallel to the horizontal plane, using a very hard grindstone made of diamond or ceramic. Thereby, sheet-like sintered bodies with a size of 7 mm in length, 7 mm in width, and 0.1 mm in thickness were obtained. Such sheet-like sintered bodies were prepared in the number of 202. A silver paste (manufactured by Shoei Chemical Inc., part No. H5698) was applied by printing to each sheet-like sintered body. Then, the sheet-like sintered bodies were stacked to form a laminate in which the silver paste was not applied to the uppermost surface and the lowermost surface. Subsequently, the resulting laminate was subjected to hot press bonding under a pressure of 1 MPa at 700°C for 2 hours. Thereby, a laminate in which sheet-like sintered body layers and inner electrode layers were alternately stacked was obtained. The thickness of the inner electrode layers was 10 µm.

In a side face of the laminate, every other inner electrode layers at portions exposed to outside in the lamination direction were covered with a glass insulator containing SiO₂ as a main component to form insulating portions. In another side face opposing the side face, every other inner electrode layers at portions exposed to outside in the lamination direction were covered with the glass insulator to form insulating portions. In each of the inner electrode layers provided with an insulating portion at one side surface, an insulating portion is not formed in another side face opposing the side face. Then, a silver paste (same as the one described above) was applied to each of the side faces of the laminate at a width of 2 mm except for a region extending to a distance of 1 mm from each end, followed by heating at 700°C for 1 hour to bake the silver paste. Thereby, a first outer electrode and a second outer electrode with a thickness of 50 µm were formed. A lead was fixed to each outer electrode, and polarization treatment was performed in which the workpiece was immersed in silicone oil at 140°C and a DC electric field of 3 kV/mm, which was larger than the coercive electric field, was applied to the outer electrodes for 2 minutes. Thereby, a multilayer piezoelectric element was obtained.

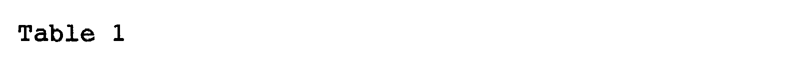

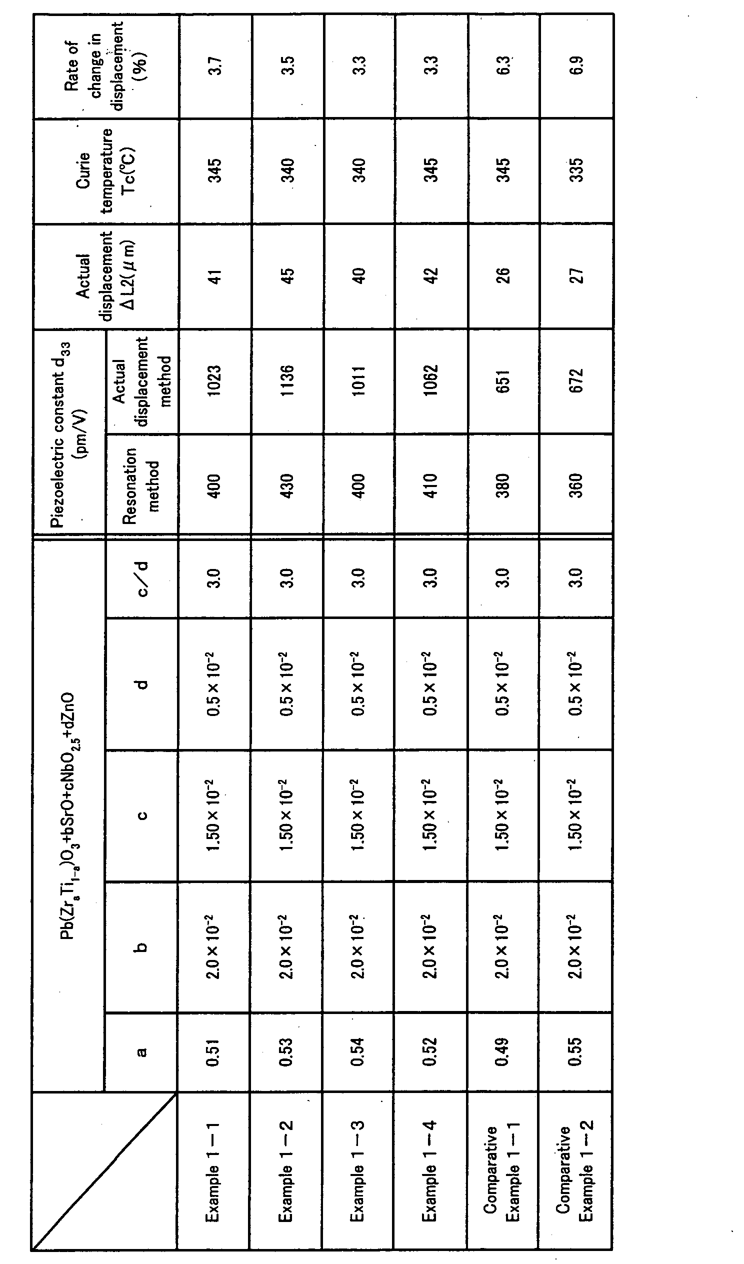

Each of the multilayer piezoelectric elements of Examples 1-1 to 1-4 and Comparative Examples 1-1 and 1-2 was measured with respect to (1) the piezoelectric constant d₃₃ determined by the resonation method, (2) the piezoelectric constant d₃₃ determined from actual displacement, (3) actual displacement ΔL2, (4) the Curie temperature Tc, and (5) the rate of change in displacement in a reliability test. Each of the measurement methods will be described.

### (1) Method of measuring piezoelectric constant (d₃₃) by resonance method

A multilayer piezoelectric element of each of the examples and the comparative examples was measured with an impedance analyzer (manufactured by Agilent Corp., part No. 4294A) according to Electronic Materials Manufacturer's Association of Japan Standard EMA-6001 to 6006.

### (2) Method of measuring piezoelectric constant (d₃₃) by actual displacement method

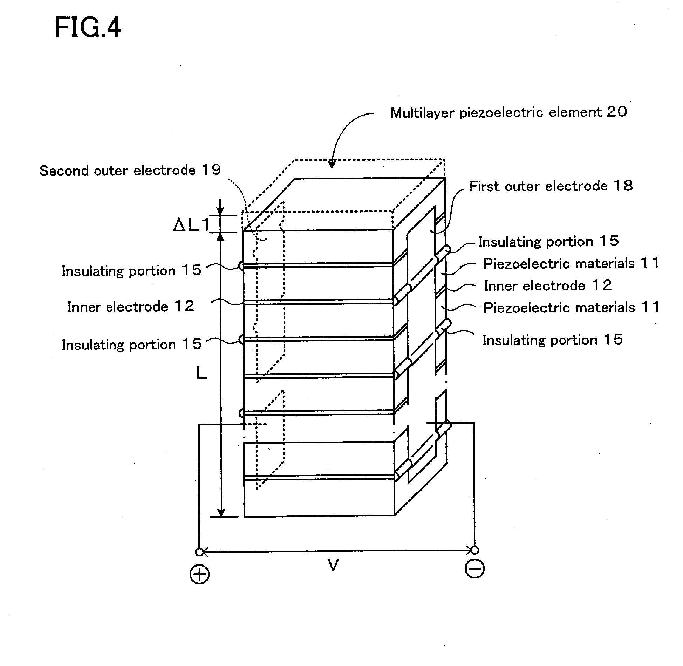

As shown in Fig. 4, a DC power supply was connected to the electrodes on both the front and back surfaces of each of the multilayer piezoelectric elements of the examples and the comparative examples to measure actual displacement ΔL1 with an electric micrometer (manufactured by TESA Co., Ltd., part No. TT60) while applying a DC electric field of 0 to 1000 V, and d₃₃ was calculated by the relational expression d₃₃ = ΔL1/V.

### (3) Method of measuring actual displacement ΔL2

A multilayer piezoelectric element of each of the examples and the comparative examples was measured with respect to actual displacement ΔL2 using an electric micrometer (manufactured by TESA Co., Ltd., part No. TT60) while applying a DC electric field of 0 to 200 V.

### (4) Method of measuring Curie temperature (Tc)

A multilayer piezoelectric element of each of the examples and the comparative examples was successively heated to 200°C to 400°C to measure the temperature at which the electrostatic capacity at 1 kHz was maximized using an impedance analyzer (manufactured by Agilent Corp., part No. 4294A). The temperature at the maximum value was determined as the Curie temperature Tc.

### (5) Method for calculating rate of change in displacement in reliability test

Reliability was evaluated by a thermal cycle test. With respect to the multilayer piezoelectric element fabricated in each of Examples and Comparative Examples, the actual displacement ΔL2 was measured according to (3) described above. Then, the multilayer piezoelectric element was subjected to the thermal cycle test in which 500 cycles were performed, with one cycle consisting of -40°C/retention time 30 minutes and 280°C/retention time 30 minutes, and left to stand at room temperature for 5 hours. Then, the actual displacement ΔL2 was measured again. The rate of change in displacement was calculated according to the following formula: $Rate of change in displacement = \left[ΔL⁢2\left(initial value\right)-ΔL⁢2\left(after testing\right)\right] / ΔL ⁢ 2 \left(initial value\right)$ $\times 100 \left(%\right)$

In Examples 1-1 to 1-4 and Comparative Examples 1 and 2, only the value of **a** was changed while the values of **b**, **c,** and **d** were fixed. As a result, as shown in Table 1, satisfactory values of the piezoelectric constant d₃₃, the actual displacement ΔL2, the Curie temperature Tc, and the rate of change in displacement were obtained within the range of 0.51 s a s 0.54. While when the value of a was 0.49 or 0.55, the actual displacement ΔL2 was significantly decreased.

### [Examples 2-1 to 2-4 and Comparative Examples 2-1 and 2-2]

Multilayer piezoelectric elements were produced by the same method as in Example 1 except that PbO, ZrO₂, TiO₂, SrO, Nb₂O₅, and ZnO were weighed so as to satisfy the compositions a to d in Examples 2-1 to 2-4 and Comparative Examples 2-1 and 2-2 shown in Table 2. Each of the multilayer piezoelectric elements was measured with respect to (1) the piezoelectric constant d₃₃ determined by the resonation method, (2) the piezoelectric constant d₃₃ determined from actual displacement, (3) actual displacement ΔL2, (4) the Curie temperature Tc, and (5) the rate of change in displacement in a reliability test. The results are summarized in Table 2.

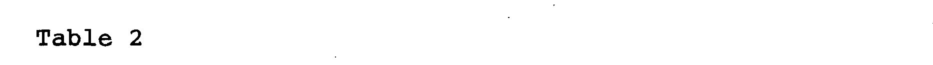

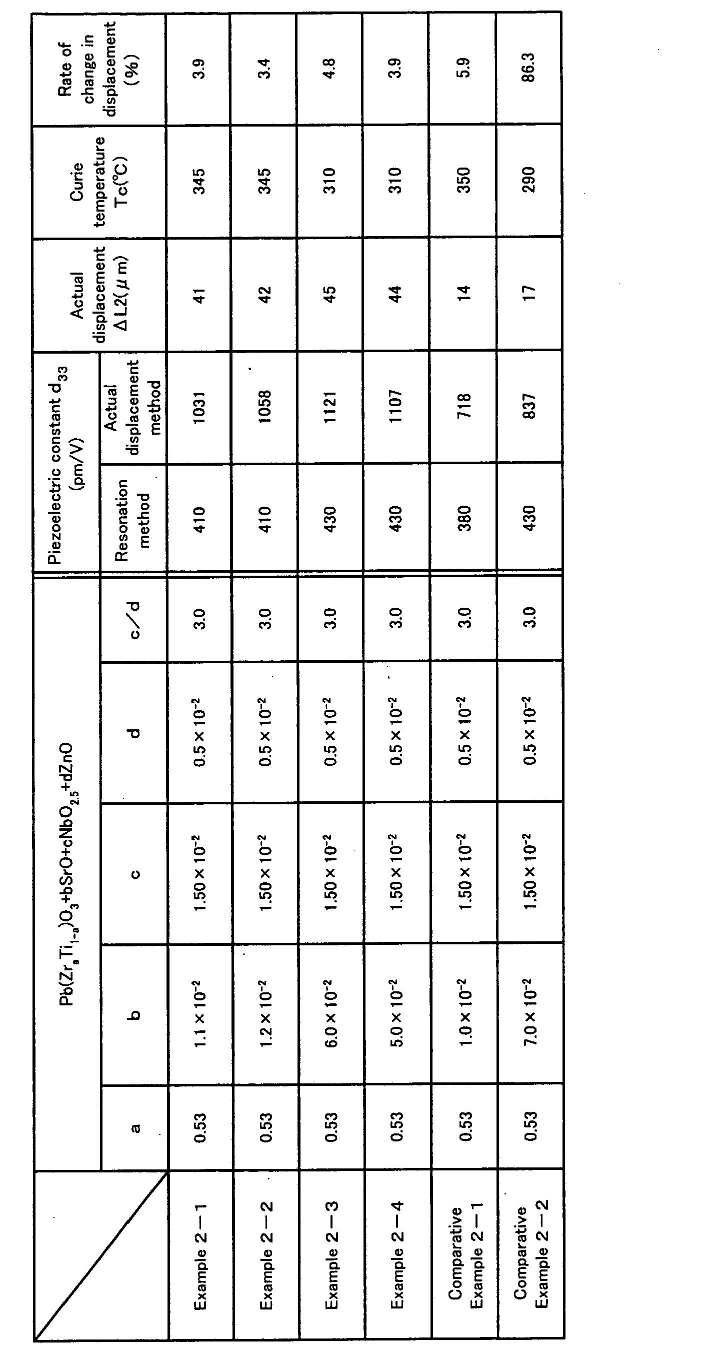

In Examples 2-1 to 2-4 and Comparative Examples 2-1 and 2-2, only the value of **b** was changed while the values of **a, c,** and **d** were fixed. As a result, as shown in Table 2, satisfactory values of the piezoelectric constant d₃₃, the actual displacement ΔL2, the Curie temperature Tc, and the rate of change in displacement were obtained within the range of 1.1 × 10⁻² ≤ **b** ≤ 6.0 × 10⁻². While when the value of **b** was 1.0 × 10⁻² or 7.0 × 10⁻², the actual displacement ΔL2 was significantly decreased. In the latter case, i.e., when the value of **b** was 7.0 × 10⁻², the Curie temperature Tc was lower than 300°C, and the rate of change in displacement was greatly increased.

### [Examples 3-1 to 3-6 and Comparative Examples 3-1 and 3-2]

Multilayer piezoelectric elements were produced by the same method as in Example 1 except that PbO, ZrO₂, TiO₂, SrO, Nb₂O₅, and ZnO were weighed so as to satisfy the compositions a to d in Examples 3-1 to 3-6 and Comparative Examples 3-1 and 3-2 shown in Table 3. Each of the multilayer piezoelectric elements was measured with respect to (1) the piezoelectric constant d₃₃ determined by the resonation method, (2) the piezoelectric constant d₃₃ determined from actual displacement, (3) actual displacement ΔL2, (4) the Curie temperature Tc, and (5) the rate of change in displacement in a reliability test. The results are summarized in Table 3.

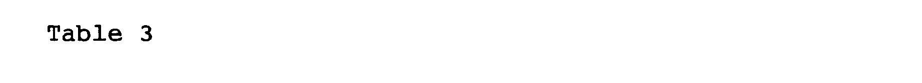

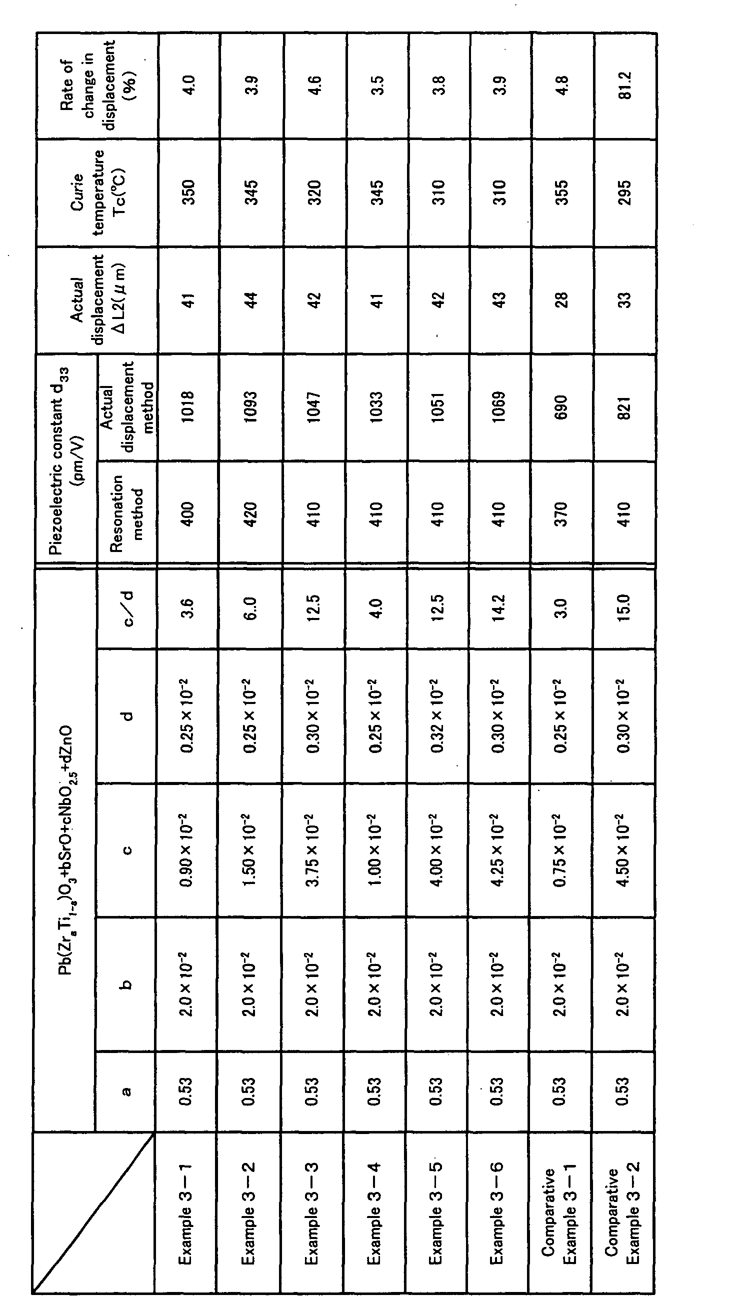

In Examples 3-1 to 3-6 and Comparative Example 3-1, the values of b and c were changed while the values of **a** and **d** were fixed. As a result, as shown in Table 3, satisfactory values of the piezoelectric constant d₃₃, the actual displacement ΔL2, the Curie temperature Tc, and the rate of change in displacement were obtained within the range of 0.9 × 10⁻² ≤ c ≤ 4.25 × 10⁻². While when the value of **c** was 0.75 × 10⁻² or 4.50 × 10⁻², the actual displacement ΔL2 was significantly decreased. In the latter case, i.e., when the value of **c** was 4.50 × 10⁻², the Curie temperature Tc was lower than 300°C, and the rate of change in displacement was greatly increased.

### [Examples 4-1 to 4-9 and Comparative Examples 4-1 and 4-4]

Multilayer piezoelectric elements were produced by the same method as in Example 1 except that PbO, ZrO₂, TiO₂, SrO, Nb₂O₅, and ZnO were weighed so as to satisfy the compositions a to d in Examples 4-1 to 4-9 and Comparative Examples 4-1 and 4-4 shown in Table 4. Each of the multilayer piezoelectric elements was measured with respect to (1) the piezoelectric constant d₃₃ determined by the resonation method, (2) the piezoelectric constant d₃₃ determined from actual displacement, (3) actual displacement ΔL2, (4) the Curie temperature Tc, and (5) the rate of change in displacement in a reliability test. The results are summarized in Table 4.

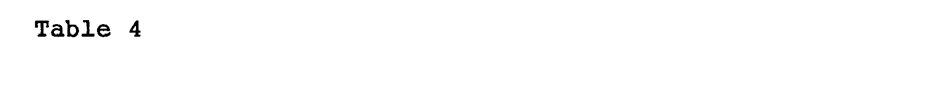

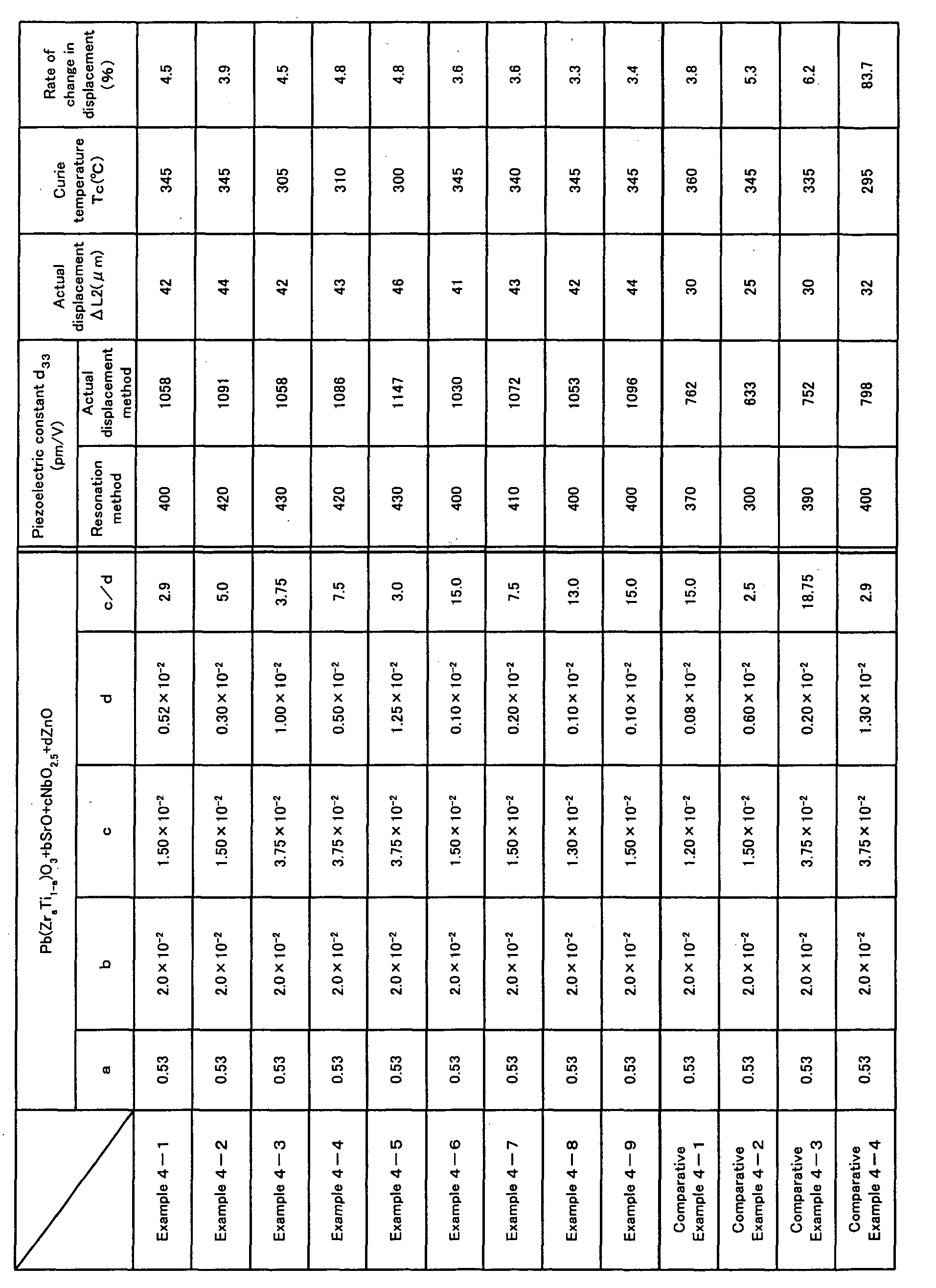

In Examples 4-1 to 4-9 and Comparative Examples 4-1 to 4-4, the values of **c** and **d** were changed while the values of **a** and **b** were fixed. As a result, as shown in Table 4, satisfactory values of the piezoelectric constant d₃₃, the actual displacement ΔL2, the Curie temperature Tc, and the rate of change in displacement were obtained within the range of 0.10 × 10⁻² ≤ d s 1.25 × 10⁻² and the range of 2.9 ≤ c/d s 15.0. While when the value of **d** was 0.08 × 10⁻² or 1.30 × 10⁻², the actual displacement ΔL2 was significantly decreased. In the latter case, i.e., when the value of d was 1.30 × 10⁻², the Curie temperature Tc was lower than 300°C, and the rate of change in displacement was greatly increased. On the other hand, when the value of **c**/**d** was 2.5 or 18.75, the actual displacement ΔL2 was greatly decreased.

The present invention claims priority on the basis of Japanese Patent Application No. 2005-056223 filed on March 1, 2005, and all contents thereof are cited in the specification.

### Industrial Applicability

A multilayer piezoelectric element of the present invention can be used in a wide field including an oscillator circuit and a filter circuit in an analogue electronic circuit as well as an actuator and a sensor.

## Claims

1. A multilayer piezoelectric element comprising:
a plurality of piezoelectric layers and a plurality of inner electrode layers alternately stacked;
a first outer electrode that electrically couples together every other inner electrode layers in the lamination direction; and
a second outer electrode that electrically couples together the remaining inner electrode layers,
wherein the piezoelectric layers are obtained by molding and firing a mixture containing a Pb component, a Zr component, a Ti component, a Sr component, a Nb component, and a Zn component; and
when the piezoelectric layers are each represented by general formula Pb(ZrₐTi_{1 a})O₃ + bSrO + cNbO_{2.5} + dZnO, the relative amounts of the individual components satisfy the relationships: $0.51 \leq a \leq 0.54 ,$ $1.1 \times {10}^{- 2} \leq b \leq 6.0 \times {10}^{- 2} ,$ $0.9 \times {10}^{- 2} \leq c \leq 4.25 \times {10}^{- 2} ,$ $0.1 \times {10}^{- 2} \leq d \leq 1.25 \times {10}^{- 2} ,$ and $2.9 \leq c / d \leq 15.0.$

2. The multilayer piezoelectric element according to Claim 1, wherein the average displacement per piezoelectric layer is 0.18 µm or more when displacement is measured by an electric micrometer while applying a DC electric field, between the first outer electrode and the second outer electrode, from 0 to 200 V at room temperature, and the Curie temperature Tc of the piezoelectric layers is 300°C or higher.

3. A multilayer piezoelectric element comprising:
a plurality of piezoelectric layers and a plurality of inner electrode layers alternately stacked;
a first outer electrode that electrically couples together every other inner electrode layers in the lamination direction; and
a second outer electrode that electrically couples together the remaining inner electrode layers,
wherein the piezoelectric layers contain lead zirconate titanate, as a base, and a Zn component;
the Curie temperature Tc of the piezoelectric layers is 300°C or higher; and
the average displacement per piezoelectric layer is 0.18 µm or more when displacement is measured by an electric micrometer while applying a DC electric field, between the first outer electrode and the second outer electrode, from 0 to 200 V at room temperature.

4. The multilayer piezoelectric element according to Claim 3, wherein the piezoelectric layers contain a Pb component, a Zr component, a Ti component, a Sr component, a Nb component, and a Zn component.

5. The multilayer piezoelectric element according to any one of Claims 1 to 4, wherein the multilayer piezoelectric element is used as a piezoelectric actuator for an automotive injector.
